# EUROPEAN PATENT APPLICATION

(11) **EP 1 162 738 A2**
(43) Date of publication of application: **12.12.2001**
(21) Application number: 01305003.4
(22) Date of filing: 08.06.2001
(51) Int. Cl.: H03H 7/01

(54) **Bandpass filter**

(30) Priority: 09.06.2000 JP 2000173089
(71) Applicant: TOKO KABUSHIKI KAISHA, Tokyo-To (JP)
(72) Inventor: Yano, Toru, c/o Toko Kabushiki Kaisha, Tamagawa-Mura, Hiki-gun, Saitama-ken (JP)
(74) Representative: Crawford, Andrew Birkby

(57) **Abstract**

A bandpass filter comprising a plurality of resonance circuits, in which coils and capacitors are connected in parallel, a first capacitor, which is connected between an input side resonance circuit and an input terminal, and a second capacitor, which is connected between an output side resonance circuit and an output terminal, the plurality of resonance circuits being electromagnetically coupled. The bandpass filter includes the first and second capacitors each face a pair of capacitance electrodes with an insulating layer therebetween, one capacitance electrode of the first capacitor and one capacitance electrode of the second capacitor face each other with an insulating layer therebetween, thereby forming a third capacitor, and another capacitance electrode of the first capacitor and another capacitance electrode of the second capacitor face each other with an insulating layer therebetween, thereby forming a fourth capacitor. The coils of the plurality of resonance circuits can be provided by alternately laminating insulating layers and coil patterns, and connecting the coil patterns between the insulating layers. The coils of the plurality of resonance circuits can also be provided by alternately laminating insulating layers and coil patterns on an insulating layer which a ground electrode is provided on, and connecting the coil patterns between the insulating layers.

## Description

### Field of the Invention

The present invention relates to a bandpass filter which is comprised by electromagnetically coupling a plurality of resonance circuits, connecting the input side resonance circuit via a first capacitor to an input terminal, and connecting the output side resonance circuit via a second capacitor to an output terminal.

### Background of the Invention

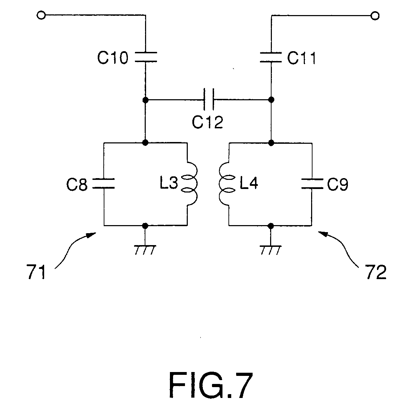

FIG. 7 shows one example of a conventional bandpass filter in which a resonance circuit 71, comprising a coil L3 and a capacitor C8 which are connected in parallel, is electromagnetically coupled to a resonance circuit 72, comprising a coil L4 and a capacitor C9 which are connected in parallel. The resonance circuit 71 connects to the input terminal via a capacitor C10. The resonance circuit 72 connects to the output terminal via a capacitor C11. A capacitor C12 is formed by electrically coupling the two resonance circuits.

In this type of bandpass filter, an attenuation pole is formed at frequencies which are higher and/or lower than the pass band. Electronic devices which such bandpass filters are installed in generally have noise at different frequencies, even though their pass band frequencies and bandwidths are roughly the same. For this reason, the frequency of the attenuation pole of the bandpass filter must be changed in accordance with the type of the electronic device.

However, when the frequency of the attenuation pole has been changed to enable conventional bandpass filters to be used in electronic devices having noise at different frequencies, the bandwidth changes considerably, making it necessary to reset the balance between the capacitive coupling and the inductive coupling, and also the capacitances of the capacitors C10 and C11. Therefore, conventional bandpass filters must be designed separately according to type even when, apart from the frequencies of the attenuation poles, their characteristics are identical. This has disadvantages of making the circuit design complex and increasing the cost of design.

### SUMMARY OF THE INVENTION

It is an object of the present invention to provide a bandpass filter in which the frequency of the attenuation pole can be set without affecting the size of the bandwidth.

The bandpass filter of this invention improves the capacitance electrodes of a first capacitor, which is connected between an input side resonance circuit and an input terminal, and a second capacitor, which is connected between an output side resonance circuit and an output terminal, thereby solving the problems mentioned above.

That is, the bandpass filter of this invention comprises a plurality of resonance circuits, in which coils and capacitors are connected in parallel, a first capacitor, which is connected between an input side resonance circuit and an input terminal, and a second capacitor, which is connected between an output side resonance circuit and an output terminal. The plurality of resonance circuits are electromagnetically coupled. The first and second capacitors are each provided facing a pair of capacitance electrodes with an insulating layer therebetween. One capacitance electrode of the first capacitor and one capacitance electrode of the second capacitor are provided facing each other with an insulating layer therebetween, thereby forming a third capacitor. Another capacitance electrode of the first capacitor and another capacitance electrode of the second capacitor are provided facing each other with an insulating layer therebetween, thereby forming a fourth capacitor.

In another aspect, the bandpass filter comprises a plurality of resonance circuits, in which coils and capacitors are connected in parallel, a first capacitor, which is connected between an input side resonance circuit and an input terminal, and a second capacitor, which is connected between an output side resonance circuit and an output terminal, the plurality of resonance circuits being electromagnetically coupled; the coils of the plurality of resonance circuits are provided by alternately laminating insulating layers and coil patterns, and connecting the coil patterns between the insulating layers. The first and second capacitors are each provided facing a pair of capacitance electrodes with an insulating layer therebetween. One capacitance electrode of the first capacitor and one capacitance electrode of the second capacitor are provided facing each other with an insulating layer therebetween, thereby forming a third capacitor. Another capacitance electrode of the first capacitor and another capacitance electrode of the second capacitor are provided facing each other with an insulating layer therebetween, thereby forming a fourth capacitor.

In yet another aspect, the bandpass filter comprises a plurality of resonance circuits, in which coils and capacitors are connected in parallel, a first capacitor, which is connected between an input side resonance circuit and an input terminal, and a second capacitor, which is connected between an output side resonance circuit and an output terminal, the plurality of resonance circuits being electromagnetically coupled. The coils of the plurality of resonance circuits are provided by alternately laminating insulating layers and coil patterns on an insulating layer which a ground electrode is provided on, and connecting the coil patterns between the insulating layers. The first and second capacitors are each provided facing a pair of capacitance electrodes with an insulating layer therebetween. At this time, a part of one capacitance electrode of the first capacitor and a part of one capacitance electrode of the second capacitor are each provided facing each other with an insulating layer therebetween, thereby forming a third capacitor. A part of another capacitance electrode of the first capacitor and a part of another capacitance electrode of the second capacitor are each provided facing each other with the insulating layer therebetween, thereby forming a fourth capacitor.

Therefore, according to the bandpass filter of the present invention, one capacitance electrode of the first capacitor and one capacitance electrode of the second capacitor form a third capacitor between the input terminal and the resonance circuit side of the second capacitor, or between the output terminal and the resonance circuit side of the first capacitor. In addition, another capacitance electrode of the first capacitor and another capacitance electrode of the second capacitor form a fourth capacitor between the output terminal and the resonance circuit side of the first capacitor, or between the input terminal and the resonance circuit side of the second capacitor.

### BRIEF DESCRIPTION OF THE DRAWINGS

FIG. 1 is an exploded perspective view of a bandpass filter according to a first embodiment of this invention;
FIG. 2 is a perspective view of the first embodiment of the bandpass filter of this invention;
FIG. 3 is a circuit diagram of the bandpass filter of this invention;
FIG. 4 is a graph showing the characteristics of bandpass filters;
FIG. 5 is a graph showing the characteristics of the relative bandwidth of bandpass filters;
FIG. 6 is an exploded perspective view of a bandpass filter according to a second embodiment of this invention; and
FIG. 7 is a circuit diagram of a conventional bandpass filter.

### DESCRIPTION OF THE PREFERRED EMBODIMENTS

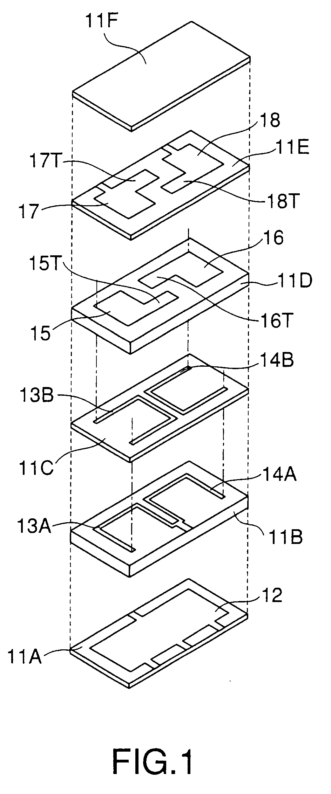

The bandpass filter of the present invention will be explained with reference to FIGS. 1 to 6.

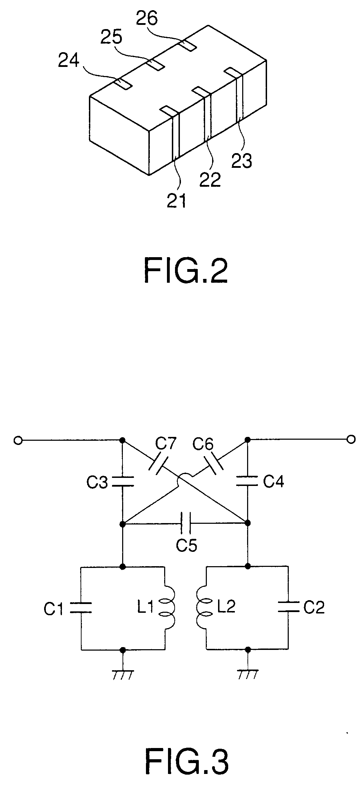

FIG. 1 is an exploded perspective view of a first embodiment of the bandpass filter of this invention, FIG. 2 is a perspective view of the first embodiment of the bandpass filter of this invention, and FIG. 3 is a circuit diagram of the bandpass filter of this invention.

In FIG. 1, reference numerals 11A to 11F represent insulating layers, reference numerals 13A, 13B, 14A, and 14B represent coil patterns, and reference numerals 15, 16, 17, and 18 represent capacitance electrodes.

The insulating layers 11A, 11B, 11C, 11D, 11E, and 11F comprise a dielectric material or a magnetic material.

A ground electrode 12 is provided on the top face of the insulating layer 11A. The ground electrode 12 extends to the opposing sides of the insulating layer 11A.

A coil pattern 13A and a coil pattern 14A are provided on the top face of the insulating layer 11B. The coil patterns 13A and 14A are arranged in line symmetry with a predetermined gap therebetween, so that they do not touch each other. One end of the coil pattern 13A is connected to one end of the coil pattern 14A, and both extend to the side faces of the insulating layer 11B.

A coil pattern 13B and a coil pattern 14B are provided on the top face of the insulating layer 11C. The coil pattern 13B and the coil pattern 14B are arranged in line symmetry with a predetermined gap therebetween, so that they do not touch each other. One end of the coil pattern 13B connects to the other end of the coil pattern 13A. One end of the coil pattern 14B connects to the other end of the coil pattern 14A.

The coil patterns 13A and 13B are connected to form a spiralling coil. Similarly, the coil patterns 14A and 14B are connected to form a spiralling coil.

A capacitance electrode 15 and a capacitance electrode 16 are provided on the top face of the insulating layer 11D. The capacitance electrode 15 has a protruding section 15T which protrudes to the capacitance electrode 16 side. The capacitance electrode 16 has a protruding section 16T which protrudes to the capacitance electrode 15 side.

A capacitance electrode 17 and a capacitance electrode 18 are provided on top of the insulating layer 11E. The capacitance electrode 17 faces the capacitance electrode 15, thereby achieves a predetermined capacitance between itself and the capacitance electrode 15. The capacitance electrode 17 has a protruding section 17T which protrudes to the captioned electrode 18 side and facing the protruding section 16T of the capacitance electrode 16. The capacitance electrode 18 faces the capacitance electrode 16, thereby achieves a predetermined capacitance between itself and the capacitance electrode 16. The capacitance electrode 18 has a protruding section 18T which protrudes to the capacitance electrode 17 side and facing the protruding section 15T of the capacitance electrode 15.

As shown in FIG. 2, terminal electrodes 21, 22, 23, 24, 25, and 26 are provided on the side faces of a laminated body which is obtained by sequentially laminating the insulating layers 11A to 11E and covering them with the protective insulating layer 11F.

Then, the terminal which connects the coil pattern 13A and the coil pattern 14A is connected to the ground electrode 12 via an external terminal 22. External terminals 21, 23, and 25 are connected to the ground electrode 12, the external electrode 24 is connected to the capacitance electrode 17, and the external electrode 26 is connected to the capacitance electrode 18.

The bandpass filter having this constitution forms a circuit such as that shown in FIG. 3. The coil patterns 13A and 13B form a coil L1. The coil patterns 14A and 14B form a coil L2. The coils L1 and L2 are electromagnetically coupled together. The capacitance (line-to-line capacitance) between the coil patterns 13A and 13B and the capacitance between the coil pattern 13A and the ground electrode 12 form a capacitor C1 in parallel with the coil L1. The capacitance (line-to-line capacitance) between the coil patterns 14A and 14B and the capacitance between the coil pattern 14A and the ground electrode 12 form a capacitor C2 in parallel with the coil L2. The coil L1 and the capacitor C1 constitute an input-side resonance circuit, and the coil L2 and the capacitor C2 constitute an output-side resonance circuit.

The capacitance electrode 15 and the capacitance electrode 17 form a capacitor C3 between the input terminal and the input-side resonance circuit. The capacitance electrode 16 and the capacitance electrode 18 form a capacitor C4 between the output terminal and the output-side resonance circuit. The protruding section 15T of the capacitance electrode 15 and the protruding section 18T of the capacitance electrode 18 form a capacitor C6 between the output terminal and the resonance circuit side of the capacitance C3. The protruding section 16T of the capacitance electrode 16 and the protruding section 17T of the capacitance electrode 17 form a capacitor C7 between the input terminal and the resonance circuit side of the capacitor C4.

Since the coil L1 and the coil L2 are electromagnetically coupled, the capacitance existing between the coil patterns of the two coils obtains a coupling capacitance C5 between the other end of the coil L1 and the other end of the coil L2.

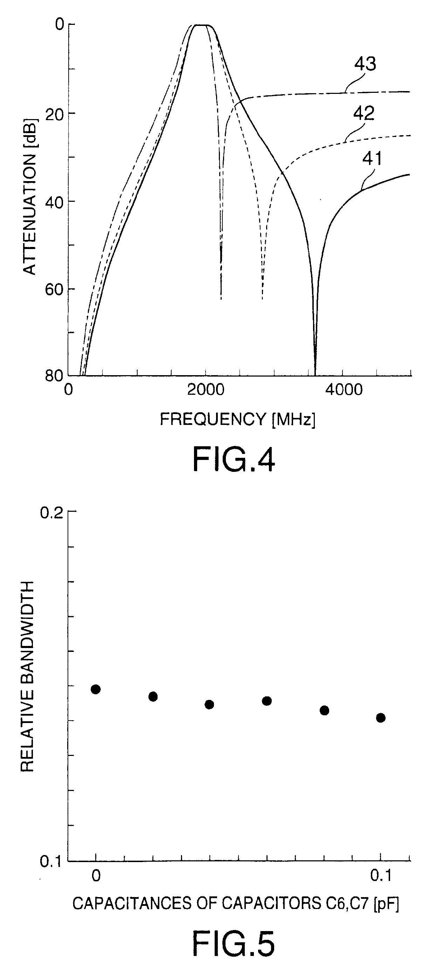

This bandpass filter produces an attenuation pole in the high-frequency side of the pass band. As shown in FIG. 4, the frequency of the attenuation pole is adjusted by changing the facing area of the protruding section 15T of the capacitance electrode 15 and the protruding section 18T of the capacitance electrode 18 and the facing area of the protruding section 16T of the capacitance electrode 16 and the protruding section 17T of the capacitance electrode 17, thereby adjusting the capacitance of the capacitor C6 and the capacitor C7.

In FIG. 4, the horizontal axis shows the frequency, the vertical axis shows the amount of attenuation, numeral 41 represents the characteristics of the conventional bandpass filter, and numerals 42 and 43 represent the characteristics of the bandpass filter when the capacitances of the capacitors C6 and C7 are 0.02 pF and 1 pF respectively. According to the bandpass filter of this invention, the frequency of the attenuation pole is set closer to the central frequency of the pass band by increasing the capacitances of the capacitors C6 and C7, thereby sharply improving the characteristics of the bandpass filter.

As shown in FIG. 5, a comparison between the relative bandwidth (bandwidth / central frequency) of a bandpass filter in which the capacitances of the capacitors C6 and C7 are 0 pf (i.e. the conventional bandpass filter) and the relative bandwidth (bandwidth / central frequency) of the bandpass filter of this invention, in which the capacitances of the capacitors C6 and C7 have been increased, shows that they are approximately constant. Therefore, in the bandpass filter of this invention, the frequency of the attenuation pole can be changed without greatly affecting the bandwidth.

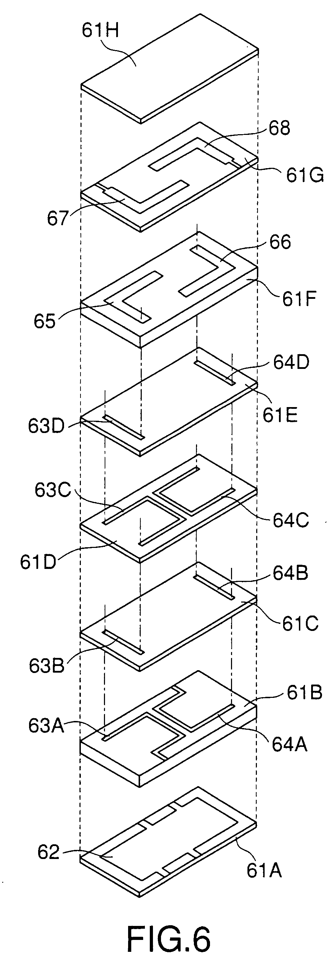

FIG. 6 is an exploded perspective view of a second embodiment of the bandpass filter of this invention.

Insulating layers 61A, 61B, 61C, 61D, 61E, 61F, 61G, and 61H are comprised of a dielectric material or a magnetic material.

A ground electrode 62 is provided on the top face of the insulating layer 61A. The ground electrode 62 extends to the opposing sides of the insulating layer 61A.

A coil pattern 63A and a coil pattern 64A are provided on the top face of the insulating layer 61B. The coil patterns 63A and 64A are provided in point symmetry with a predetermined gap therebetween, so that they do not touch each other. One end of the coil pattern 63A and one end of the coil pattern 64A extend separately to opposite side faces of the insulating layer 61B.

A coil pattern 63B and a coil pattern 64B are provided on the top face of the insulating layer 61C. The coil patterns 63B and 64B are provided in point symmetry with a predetermined gap therebetween, so that they do not touch each other. One end of the coil pattern 63B is connected to the other end of the coil pattern 63A. One end of the coil pattern 64B is connected to the other end of the coil pattern 64A.

A coil pattern 63C and a coil pattern 64C are provided on the top face of the insulating layer 61D. The coil patterns 63C and 64C are provided in point symmetry with a predetermined gap therebetween, so that they do not touch each other. One end of the coil pattern 63C is connected to the other end of the coil pattern 63B. One end of the coil pattern 64C is connected to the other end of the coil pattern 64B.

A coil pattern 63D and a coil pattern 64D are provided on top of the insulating layer 61E. The coil patterns 63D and 64D are arranged in point symmetry with a predetermined gap therebetween, so that they do not touch each other. One end of the coil pattern 63D is connected to the other end of the coil pattern 63C. One end of the coil pattern 64D is connected to the other end of the coil pattern 64C.

The coil patterns 63A, 63B, 63C, and 63D are sequentially connected to obtain a spiralling coil. The coil patterns 64A, 64B, 64C, and 64D are sequentially connected to obtain a spiralling coil.

A capacitance electrode 65 and a capacitance electrode 66 are provided on the top face of the insulating layer 61F. The capacitance electrode 65 and the capacitance electrode 66 are L-shaped, and are arranged in point symmetry on the insulating layer 61F.

A capacitance electrode 67 and a capacitance electrode 68 are provided on the top face of the insulating layer 61G. The capacitance electrode 67 is L-shaped, and partially faces the capacitance electrodes 65 and 66. The capacitance electrode 68 is L-shaped, and partially faces the capacitance electrodes 66 and 65. The extracted end of the capacitance electrode 67 and the extracted end of the capacitance electrode 68 extend to side faces of the insulating layer 61G.

The insulating layers 61A to 61G are sequentially laminated and covered with a protective insulating layer 11H, and terminal electrodes are provided to the side faces of this laminated body.

The present invention is not limited to the embodiments described above. For instance, in the abovementioned embodiments, the third capacitor is connected between the output terminal and the resonance circuit side of the first capacitor, and the fourth capacitor is connected between the input terminal and the resonance circuit side of the second capacitor, but in an alternative arrangement, the third capacitor is connected between the input terminal and the resonance circuit side of the second capacitor, and the fourth capacitor is connected between the output terminal and the resonance circuit side of the first capacitor.

This invention can also be applied in a bandpass filter in which three or more resonance circuits are electromagnetically coupled.

As described above, the bandpass filter of this invention comprises a first capacitor, connected between the input side resonance circuit and the input terminal, and a second capacitor, connected between the output side resonance circuit and the output terminal. The first and second capacitors are each provided facing a pair of capacitance electrodes with an insulating layer therebetween. One of the capacitance electrodes of the first capacitor and one of the capacitance electrodes of the second capacitor are provided facing each other with an insulating layer therebetween, thereby forming a third capacitor. The other of the capacitance electrodes of the first capacitor and the other of the capacitance electrodes of the second capacitor are provided facing each other with an insulating layer therebetween, thereby forming a fourth capacitor. Thus a third capacitor is connected between the input terminal and the resonance circuit side of the second capacitor, or between the output terminal and the resonance circuit side of the first capacitor, and a fourth capacitor is connected between the output terminal and the resonance circuit side of the first capacitor, or between the input terminal and the resonance circuit side of the second capacitor. Therefore, the bandpass filter of this invention allows the frequency of the attenuation pole to be set by adjusting the capacitances of the third and fourth capacitors, without affecting the bandwidth.

## Claims

1. A bandpass filter comprising a plurality of resonance circuits, in which coils and capacitors are connected in parallel, a first capacitor, which is connected between an input side resonance circuit and an input terminal, and a second capacitor, which is connected between an output side resonance circuit and an output terminal, said plurality of resonance circuits being electromagnetically coupled, the bandpass filter being **characterized in that**
said first and second capacitors each face a pair of capacitance electrodes with an insulating layer therebetween, one capacitance electrode of said first capacitor and one capacitance electrode of said second capacitor face each other with an insulating layer therebetween, thereby forming a third capacitor, and another capacitance electrode of said first capacitor and another capacitance electrode of said second capacitor face each other with an insulating layer therebetween, thereby forming a fourth capacitor.

2. The bandpass filter as described in Claim 1, wherein said third capacitor is connected between the input terminal and the resonance circuit side of said second capacitor, and said fourth capacitor is connected between the output terminal and the resonance circuit side of said first capacitor.

3. The bandpass filter as described in Claim 1, wherein said third capacitor is connected between the ouput terminal and the resonance circuit side of said first capacitor, and said fourth capacitor is connected between the input terminal and the resonance circuit side of said second capacitor.

4. A bandpass filter comprising a plurality of resonance circuits, in which coils and capacitors are connected in parallel, a first capacitor, which is connected between an input side resonance circuit and an input terminal, and a second capacitor, which is connected between an output side resonance circuit and an output terminal, said plurality of resonance circuits being electromagnetically coupled, the bandpass filter being **characterized in that**
said coils of said plurality of resonance circuits are provided by alternately laminating insulating layers and coil patterns, and connecting the coil patterns between the insulating layers; and
said first and second capacitors each face a pair of capacitance electrodes with an insulating layer therebetween, one capacitance electrode of said first capacitor and one capacitance electrode of said second capacitor face each other with an insulating layer therebetween, thereby forming a third capacitor, and another capacitance electrode of said first capacitor and another capacitance electrode of said second capacitor face each other with an insulating layer therebetween, thereby forming a fourth capacitor.

5. The bandpass filter as described in Claim 4, wherein said third capacitor is connected between the input terminal and the resonance circuit side of said second capacitor, and said fourth capacitor is connected between the ouput terminal and the resonance circuit side of said first capacitor.

6. The bandpass filter as described in Claim 4, wherein said third capacitor is connected between the ouput terminal and the resonance circuit side of said first capacitor, and said fourth capacitor is connected between the input terminal and the resonance circuit side of said second capacitor.

7. A bandpass filter comprising a plurality of resonance circuits, in which coils and capacitors are connected in parallel, a first capacitor, which is connected between an input side resonance circuit and an input terminal, and a second capacitor, which is connected between an output side resonance circuit and an output terminal, said plurality of resonance circuits being electromagnetically coupled, the bandpass filter being **characterized in that**
said coils of said plurality of resonance circuits are provided by alternately laminating insulating layers and coil patterns on an insulating layer which a ground electrode is provided on, and connecting the coil patterns between the insulating layers; and
said first and second capacitors each face a pair of capacitance electrodes with an insulating layer therebetween, one capacitance electrode of said first capacitor and one capacitance electrode of said second capacitor face each other with an insulating layer therebetween, thereby forming a third capacitor, and another capacitance electrode of said first capacitor and another capacitance electrode of said second capacitor face each other with said insulating layers therebetween, thereby forming a fourth capacitor.

8. The bandpass filter as described in Claim 7, wherein said third capacitor is connected between the input terminal and the resonance circuit side of said second capacitor, and said fourth capacitor is connected between the ouput terminal and the resonance circuit side of said first capacitor.

9. The bandpass filter as described in Claim 7, wherein said third capacitor is connected between the ouput terminal and the resonance circuit side of said first capacitor, and said fourth capacitor is connected between the input terminal and the resonance circuit side of said second capacitor.
